(19)

Europäisches Patentamt

European Patent Office

Office européen des brevets

(11) **EP 2 732 065 B1**

(12) **EUROPÄISCHE PATENTSCHRIFT**

(45) Veröffentlichungstag und Bekanntmachung des Hinweises auf die Patenterteilung:
**13.02.2019   Patentblatt 2019/07**

(21) Anmeldenummer: **12737208.4**

(22) Anmeldetag: **12.07.2012**

(51) Int Cl.:
*C23C 8/10* (2006.01)          *C23C 8/36* (2006.01)
*C23C 8/38* (2006.01)

(86) Internationale Anmeldenummer:
**PCT/EP2012/002947**

(87) Internationale Veröffentlichungsnummer:
**WO 2013/007389 (17.01.2013 Gazette 2013/03)**

(54) **VERFAHREN ZUM AUSBILDEN EINER SCHICHT AUF EINEM SUBSTRAT BEI TIEFEN TEMPERATUREN**

METHOD FOR FORMING A LAYER ON A SUBSTRATE AT LOW TEMPERATURES

PROCÉDÉ POUR FORMER UNE COUCHE SUR UN SUBSTRAT À BASSES TEMPÉRATURES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.07.2011   DE 102011107072**

(43) Veröffentlichungstag der Anmeldung:
**21.05.2014   Patentblatt 2014/21**

(73) Patentinhaber:
• **HQ-Dielectrics GmbH**
  **89156 Dornstadt (DE)**
• **centrotherm photovoltaics AG**
  **89143 Blaubeuren (DE)**

(72) Erfinder:
• **NIESS, Jürgen**
  **89567 Sontheim (DE)**

• **LERCH, Wilfried**
  **89160 Dornstadt (DE)**
• **KEGEL, Wilhelm**
  **89150 Laichingen (DE)**
• **GSCHWANDTNER, Alexander**
  **80687 München (DE)**

(74) Vertreter: **Emde, Eric**
**Wagner & Geyer**
**Gewürzmühlstrasse 5**
**80538 München (DE)**

(56) Entgegenhaltungen:
| | |
|---|---|
| **EP-A1- 1 361 605** | **WO-A1-2010/015385** |
| **US-A1- 2006 269 291** | **US-A1- 2009 263 919** |
| **US-A1- 2010 247 805** | **US-B1- 6 399 520** |
| **US-B1- 6 652 709** | |

EP 2 732 065 B1

**Beschreibung**

Die vorliegende Erfindung betrifft ein Verfahren zum Ausbilden einer Schicht auf einem Substrat, insbesondere auf einem Halbleitersubstrat und bei Temperaturen unter 200°C.

Bei der Herstellung von elektronischen Bauelementen, wie beispielsweise Speicherchips, Mikroprozessoren, aber auch in der Photovoltaik oder im Bereich von Flachbildschirmen sind unterschiedliche Produktionsschritte zur Herstellung eines Endprodukts notwendig. Dabei werden während der Herstellung der Produkte unterschiedliche Schichten zum Aufbau der elektronischen Bauelemente aufgebracht. Eine wichtige Klasse dieser Schichten sind dielektrische Schichten, welche unterschiedliche Schichten gegeneinander isolieren. Wie auch bei allen anderen Schichtaufbauten ist es notwendig, die dielektrischen Schichten fehlerfrei und zuverlässig aufzubauen, um die Funktionalität des Bauelements sicherzustellen.

Für die Ausbildung von dielektrischen oder anderen Schichten auf einem Substrat sind unterschiedliche Verfahren bekannt. Ein Beispiel eines solchen Verfahrens ist die Ausbildung thermischer Oxidschichten auf Halbleitersubstraten in so genannten Öfen oder Schnellheizanlagen (RTP-Anlagen). Dort können kontrolliert dielektrische Schichten mit guten elektrischen Eigenschaften erzeugt werden.

Ein Nachteil einer solchen thermischen Oxidation kann jedoch unter anderem in den verwendeten Temperaturen liegen, bei denen die Oxidation durchgeführt wird, da diese die darunterliegenden Strukturen beeinträchtigen können. Daher ist man bei solchen Systemen immer bemüht, das thermische Budget der Behandlung, beispielsweise durch besonders rasche Erwärmung und/oder Abkühlung des Substrats zu reduzieren, was aber nur bedingt gelingt. Darüber hinaus kann die Schichtbildung insbesondere bei der thermischen Oxidation durch die Orientierung des Halbleiterkristalls beeinflusst werden, was beispielsweise bei polykristallinen Siliziumsubstraten oder 3-dimensionalen Strukturen zu ungleichmäßigen Schichtdicken und der Ausprägung von unerwünschter Strukturbildung führen kann.

Darüber hinaus ist auch eine Plasmabehandlung von Substraten zur Ausbildung dielektrischer Schichten bekannt. So beschreibt z.B. das US Patent 7,381,595 B2 eine Niedertemperatur-Plasmaoxidation eines Siliziumhalbleiters unter Verwendung eines hochdichten Plasmas. Bei diesem Patent wird die Plasmaquelle, die nachfolgend insgesamt als Plasmaelektrode bezeichnet wird, durch zwei plattenförmige einander gegenüber liegende Elektroden gebildet. Die Substrate werden zwischen den beiden plattenförmigen einander gegenüber liegenden Elektroden aufgenommen und bilden selbst einen Teil der einen Elektrode. Die bei der Plasmaoxidation verwendeten Temperaturen verringern wesentlich das thermische Budget gegenüber einer thermischen Oxidation, und können hierdurch die damit verbundenen Nachteile verbessern. Eine ähnliche Plasmaelektrode, die aus zwei gegenüber liegenden plattenförmigen Elektroden gebildet wird, und bei der ein zu behandelndes Substrat zwischen den Elektroden angeordnet ist, ergibt sich aus der US 6,037,017 A. Bei dieser Plasmaelektrode ist der Abstand zwischen den Elektroden in Abhängigkeit von unterschiedlichen Prozessparametern einstellbar. Weitere Plasmaelektroden dieses Typs sind aus der US2007/0026540 A1, der US 5,492,735 sowie der US 5,281,557 bekannt.

Die in diesen Patenten beschriebene Plasmaoxidation kann jedoch zu einer ungleichmäßigen Oxidschicht führen und insbesondere können die elektrischen Eigenschaften der so gebildeten Schichten ungenügend sein.

Aus der US 2009 263 919 A1, der US 2010 247 805 A1 und auch der EP 1 361 605 A1, ist jeweils eine Plasmaoxidation eines Substrats bekannt, bei dem ein Plasma aus einem Sauerstoff enthaltenden Gas mittels Mikrowellen erzeugt wird, die über eine planare Schlitzantenne eingekoppelt werden.

In der WO 2010/015385 A ist eine alternative, stabförmige Mikrowellenplasmaelektrode beschrieben, bei der ein Innenleiter in einem ersten Teilbereich vollständig von einem Außenleiter umgeben ist. Benachbart zu diesem Teilbereich schließt sich ein Teilbereich an, in dem der Außenleiter eine sich zu einem freien Ende erweiternde Öffnung vorsieht. Im Bereich der sich erweiternden Öffnung wird Mikrowellenleistung zur Erzeugung eines Plasmas ausgekoppelt. Eine weitere stabförmige Plasmaelektrode mit Innenleiter, Außenleiter und einer Auskopplungsstruktur ist zum Beispiel aus der DE 197 22 272 bekannt. Solche stabförmigen Plasmaelektroden können einem zu behandelnden Substrat gegenüberliegend angeordnet werden und das Substrat ist nicht zwischen den das Plasma erzeugenden Elektroden angeordnet. Mit solchen Plasmaelektroden lassen sich verbesserte Bearbeitungsergebnisse erzielen.

Die Weiterentwicklung in der Produktion von Halbleitern erfordert in mehreren Bereichen die Herstellung von Dielektrika, speziell von $SiO_2$, bei immer niedrigeren Temperaturen. Typische Anwendungen, bei denen die Herstellung von Oxiden bei Temperaturen unter 200 °C erfolgen sollten, um schon gebildete Schichten nicht zu beeinflussen, sind z.B. TSVs (Through Silicon Vias) im Backend Bereich, oder die Erzeugung von Transistoren nach dem GateFirst Prinzip, aber auch nach dem GateLast Prinzip. Darüberhinaus müssen bei derzeitigen und zukünftigen 3D Chip Strukturen sehr gute konformale $SiO_2$ Schichten gewachsen werden bzw. konformal $Si_3N_4$ Schichten reoxidiert werden. Dabei muss die Qualität der bei diesen Temperaturen hergestellten Oxide sehr hoch sein. Bei den oben genannten Methoden sind qualitativ hochwertige Oxide üblicherweise nur bei hohen (>700°C) oder mittleren Temperaturen (300 - 700°C) herstellbar.

Bei den bisher bekannten Plasmaoxidationen welche zum Teil die Herstellung hochwertiger Oxide bei mittleren Temperaturen (300 - 700°C) ermöglichen, wurde eine durch das Plasma bedingte Aufheizung des Substrats als gegeben angesehen und nicht als Problem gesehen. Die Prozessabläufe wurden so aufgebaut, dass mittlere Temperaturen (300 - 700°C) erlaubt und mitunter gewünscht waren, um qualitativ hochwertige Oxide zu wachsen. Mit zunehmender Integration und Skalierung der Halbleiterstrukturen ist dies aber nicht mehr möglich. Die hierfür notwendigen alternativen Materialien und auch die kleineren Dimensionen lassen solche Temperaturen von 300 - 700°C nicht mehr unbedingt zu.

Ausgehend von dem oben genannten Stand der Technik liegt der vorliegenden Erfindung die Aufgabe zugrunde, ein Verfahren zum Ausbilden einer Oxidschicht auf einem Substrat bei Temperaturen unter 200 °C vorzusehen

Erfindungsgemäß ist hierfür ein Verfahren zum Ausbilden einer Oxidschicht auf einem Substrat nach Anspruch 1 vorgesehen. Weitere Ausgestaltungen der Erfindung ergeben sich aus den Unteransprüchen.

Das Verfahren weist das Erzeugen eines Plasmas benachbart zu wenigstens einer Oberfläche des Substrats auf, wobei das Plasma mittels Mikrowellen aus einem Sauerstoff enthaltenden Gas oder Gasgemisch erzeugt wird, wobei die Mikrowellen von wenigstens einem Magnetron über wenigstens ein dem Substrat gegenüberliegenden Mikrowellenstab, der einen Außenleiter und einen Innenleiter aufweist, in das Gas, das sich in einer Prozesskammer befindet, eingekoppelt werden. Bei dem Verfahren werden wenigstens die folgenden Prozessbedingungen eingestellt:

mittlere Mikrowellen-Leistungsdichte P = 0,8 - 10 W/cm$^2$
Plasmadauer t = 0.1 - 600 s;
Prozesskammerdruck p = 2,67 - 266,64 Pa (20 - 2000 mTorr);

Abstand Substratoberfläche zu Mikrowellenstab d = 5 - 120 mm, wobei die oben genannten und gegebenenfalls weitere Prozessbedingungen derart aufeinander abgestimmt werden, dass das Substrat auf einer Temperatur unter 200°C gehalten wird und ein Oxidwachstum auf der zum Plasma weisenden Oberfläche des Substrats induziert wird. Der Abstand Substratoberfläche zu Mikrowellenstab wird bei einer Ausführungsform, bei der der Mikrowellenstab von einem dielektrischen Hüllrohr, beispielsweise aus Quarzglas, umgeben ist, vom Hüllrohr aus gemessen, ansonsten von der Außenoberfläche des Mikrowellenstabes. Die Plasmadauer bezieht sich auf die Gesamtzeit zu der ein Plasma besteht, was auch durch ein gepulstes Plasma mit mehreren zeitlich aufeinanderfolgenden Plasmen erreicht werden kann. Die mittlere Mikrowellen-Leistungsdichte bezieht Änderungen während des Prozesses mit ein.

Vorzugsweise liegen die Werte bei mittlere Mikrowellen-Leistungsdichte P = 0,8 - 10 W/cm$^2$, Plasmadauer t = 0.1 - 300s (insbesondere t = 0,1 - 150s), Prozesskammerdruck p = 10,67 - 133,32 Pa (80 - 1000 mTorr), und Abstand Substratoberfläche zu Mikrowellenstab d = 8 - 80 mm.

Der oben genannte Variablensatz ermöglicht die Herstellung von qualitativ hochwertigen Oxiden bei Temperaturen unter 200°C. Treibende Kraft für die Oxidation ist bei diesem Verfahren ein auf dem Substrat durch das Mikrowellenplasma erzeugtes elektrisches Potential, welches unabhängig von der Struktur der Substratoberfläche wirkt. Auch bei der hier beschriebenen Plasmaoxidation wird das Substrat durch das Plasma geheizt, auch wenn dieser Effekt nur sekundär ist. Dadurch wird dem Substrat erlaubt, sich je nach Prozessbedingungen auf Temperaturen > 200°C zu erwärmen. Die hier zugrunde liegende Idee liegt darin, die Prozessvariablen (Abstand, Druck, Zeit, Leistung) so zu wählen, dass Oxide mit den geforderten Dicken trotzdem bei niedrigen Temperaturen (< 200 °C) gewachsen werden können.

Durch die kleine Wachstumstemperatur in Kombination mit dem eingesetzten Mikrowellenplasma kann eine hohe Konformität beim Wachstum in technologisch relevanten Teilbereichen erzielt werden und eine verbesserte Grenzflächenqualität durch verminderte Diffusion erreicht werden. Das entstehende Oxid ist in der Regel sehr dicht und kann auch als Diffusionsbarriere eingesetzt werden. Das Verfahren erlaubt auch eine Reoxidation von Siliziumnitrid. Durch die kleine Wachstumstemperatur findet praktisch keine Redistribution von Dotanten in zuvor ausgebildeten Schichten während des Oxidwachstums statt. Die elektrische Schichtqualität ist bei Verwendung dieses Verfahrens vergleichbar mit der von thermischen Oxiden. Wollte man bei letzteren die Wachstumstemperatur verringern, so müsste man zu einer Nassoxidation mit hohem [OH]-Anteil übergehen, was aber wiederum zu einer Degradation der Schichtqualität führt, obwohl die minimale Temperatur für ein thermisches Oxidwachstum noch weit oberhalb des hier betrachteten Temperaturbereichs liegt. Wie erwähnt ist die treibende Kraft für die Plasmaoxidation bei diesem Verfahren das auf dem Substrat erzeugte elektrische Potential. Da dieses unabhängig von der Oberflächenstruktur der Substratoberfläche wirkt, ergibt sich eine hohe Konformität und ein sehr gutes Corner Rounding, z.B. bei Oxiden für Shallow Trench Isolation, Deep Trenches oder Nano Wires.

Zum Erzeugen eines Oxidwachstums von < 4,5 nm bei einer Substrattemperatur von T < 200°C werden die oben genannten Prozessbedingungen des Anspruchs 1 so eingestellt, dass sie die folgende Gleichung erfüllen:

$$P^A \cdot t^B \cdot p^C \cdot \exp(-(d-d_0)/\lambda) < K,$$

wobei die Gleichungsparameter folgendermaßen definiert sind:

$d_0$ ist ein Abstandsoffset in [mm] im Bereich von 0 - 30,

λ ist eine charakteristische Länge in [mm] im Bereich 30 - 120,

A, B und C sind wählbare Koeffizienten im Bereich

A = 0,8 - 1,5; B = 0,5 - 1,3; und C = -1 - -0,3, und

K ist eine Konstante im Bereich 11 - 4. Dabei kann zum Beispiel der Abstandskoeffizient einer Eindringtiefe der Mikrowellen in den, den Mikrowellenstab umgebenden, Raum und die charakteristische Länge einer abfallenden Plasma-, Ionen-, oder Elektronendichte entsprechen. Die mittlere Mikrowellen-Leistungsdichte P wird dabei in [W/cm$^2$] angegeben, die Plasmabrenndauer t in [s], der Kammerdruck p in [Pa] und der Abstand Plasmastab zu Wafer in [mm].

Vorzugsweise liegen die zuvor genannten Parameter in den folgenden Bereichen: $d_0$ = 0 - 10 mm; λ = 35 - 80 mm; A = 1 - 1,2; B = 0,8 - 1; C = -0,8 - -0,7; und K = 8 - 4

Bei einer Ausführungsform der Erfindung liegen die zuvor genannten Parameter bei $d_0$ = 0 mm; A = 70 mm; A = 1,1; B = 0,9; C = -2/3; und K = 4.

Die mittlere Mikrowellen-Leistungsdichte P zum Erzeugen des Plasmas sollte bei wenigstens 0,8 W/cm$^2$ liegen, um ein ausreichend hohes elektrisches Potential für eine Oxidation zu erreichen.

Vorzugsweise wird das Plasma über wenigstens einen einseitig mit Mikrowellen beaufschlagten Mikrowellenstab erzeugt, wobei der Außenleiter eine sich zu einem freien Ende der Elektrode erweiternde Auskopplungsöffnung bildet. Ein solcher Mikrowellenstab ermöglicht ein besonders homogenes Plasma. Wenigstens ein entsprechender Mikrowellenstab könnte auch auf der gegenüberliegenden Seite des Substrats angeordnet sein, um benachbart zur anderen Seite ein Plasma erzeugen zu können.

Um eine gute Oxidation zu erreichen, enthält das Gas vorzugsweise in einer Größenordnung von 6 - 100%, $O_2$ oder eine beliebige $H_2/O_2$ Mischung wobei der Rest ein inertes Gas ist (z.B. Ar, He, Xe, Kr). Alternativ kann das Gas auch $N_2$, NO, $N_2O$, $NH_3$ oder $D_2$ enthalten.

Um eine Aufheizung des Substrats durch das Plasma zu verringern kann eine Gitterstruktur zwischen dem wenigstens einen Mikrowellenstab und dem Substrat vorgesehen sein, die über wenigstens einen Teilabschnitt des Verfahrens, bei dem das Plasma erzeugt ist, gekühlt wird. Es ist auch möglich, das Substrat während des Verfahrens über seine Rückseite zu kühlen.

Das obige Verfahren ist insbesondere für die Oxidation eines Siliziumsubstrats beliebiger Form und Dimension geeignet.

Die Erfindung wird nachfolgend unter Bezugnahme auf die Figuren näher erläutert; in den Zeichnungen zeigt:

Fig. 1        eine schematische Schnittansicht durch eine Vorrichtung zum Durchführen des erfindungsgemäßen Verfahrens;

Fig. 2        eine schematische Schnittansicht durch eine alternative Vorrichtung zum Durchführen des erfindungsgemäßen Verfahrens;

Fig. 3 bis 6    Kurven von zeitabhängigen Temperaturerhöhung eines Wafers während einer Plasmaoxidation;

Fig. 7        eine Kurve einer Wafertemperatur in Abhängikeit vom Oxidwachstum auf einem Wafer während einer Plasmaoxidation; und

Fig. 8        Kurven eines zeitabhängigen Oxidwachstums auf einem Wafer während einer Plasmaoxidation bei einer Substrattemperatur unterhalb 200 °C.

Die in der nachfolgenden Beschreibung verwendeten relativen Begriffe, wie zum Beispiel links, rechts, über und unter beziehen sich auf die Zeichnungen und sollen die Anmeldung in keiner Weise einschränken, auch wenn sie bevorzugte Anordnungen bezeichnen können.

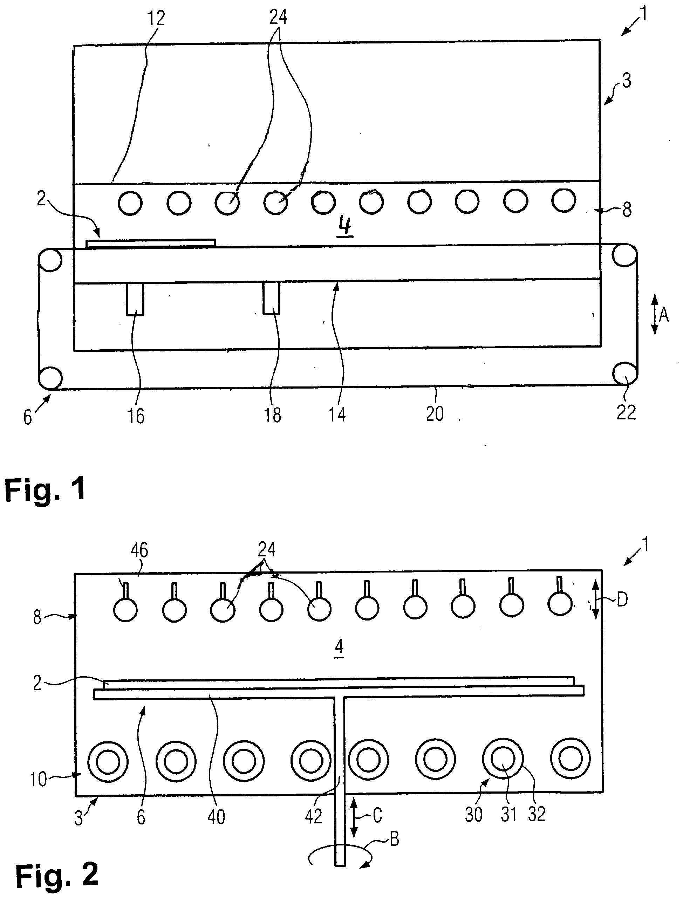

Fig. 1 zeigt eine schematische Schnittansicht durch eine Vorrichtung 1 zum Ausbilden von dielektrischer Schichten, insbesondere Oxidschichten auf einem Substrat 2. Die Vorrichtung 1 besitzt ein nur im Umriss angedeutetes Vakuumgehäuse 3, das eine langgestreckte Prozesskammer des Durchlauftyps 4 definiert. Die Vorrichtung 1 weist ferner einen Transportmechanismus 6 und eine Plasmaeinheit 8 auf. Zusätzlich kann auch eine Kühleinheit vorgesehen sein, die im Bereich des Transportmechanismus angeordnet ist.

Als Substrate 2 können in der Vorrichtung 1 unterschiedliche Substrate und insbesondere Halbleitersubstrate, wie Siliziumsubstrate mit einer Oxidschicht versehen werden. Während der Beschichtung kann das Substrat von einem nicht dargestellten Schutzelement wenigstens teilweise umgeben sein, das in derselben Ebene wie das Substrat liegt, um Randeffekte bei der Beschichtung zu vermeiden und die physikalische Oberfläche des Substrats virtuell zu vergrößern. Das Schutzelement sollte bevorzugt die gleichen oder zumindest ähnliche physikalische Eigenschaft wie das Substrat aufweisen. Das Vakuumgehäuse 3 besitzt geeignete, nicht gezeigte Schleusen zum Ein- und Ausbringen der Substrate 2 in die Prozesskammer 4.

Die Prozesskammer 4 wird unter anderem durch eine obere Wand 12 sowie eine untere Wand 14 begrenzt. Die obere Wand 12, ist beispielsweise aus Aluminium aufgebaut und derart behandelt, dass Metallverunreinigungen oder Partikel in der Prozesskammer vermieden werden. Die obere Wand 12 und die untere Wand 14 erstrecken sich im Wesentlichen Parallel zueinander, können aber auch zueinander abgewinkelte Bereiche aufweisen, wie es beispielsweise aus der nicht vorveröffentlichten DE 10 2011 100 024 bekannt ist, die insofern durch Bezugnahme aufgenommen ist. Ein schräger Wandabschnitt könnte so angeordnet sein, dass sich die Prozesskammer von einem Eingangsende zu einem Ausgangsende verjüngt und sich dann ein gerader Bereich anschließt.

Im Bereich der unteren Wand 14 ist eine Vakuumpumpe 16 vorgesehen, über die die Prozesskammer 4 abgepumpt werden kann. Die Pumpe kann aber auch an einem anderen Ort vorgesehen sein und es können auch mehrere vorgesehen sein. Ferner ist im Bereich der unteren Wand 14, ein Pyrometer 18 für eine Temperaturmessung des Substrats 2 vorgesehen. Statt eines Pyrometers kann aber auch eine andere Temperaturmessvorrichtung an einem anderen Ort der Prozesskammer oder auch direkt am Substrat 2 vorgesehen sein, die zum Beispiel auch von oben her die Temperatur des Substrats 2 messen kann. Es können auch mehrere Temperaturmessvorrichtungen vorgesehen sein. Die Prozesskammer 4 verfügt darüber hinaus über wenigstens eine nicht gezeigte Gaszuleitung, über die ein Prozessgas in die Prozesskammer 4 eingeleitet werden kann.

Die Transporteinheit 6 besteht im Wesentlichen aus einem Endlostransportband 20, das über eine Vielzahl von Umlenk- und/oder Transportrollen 22 umlaufend geführt ist. Die normale Umlaufrichtung für eine Behandlung des Substrats 2 ist dabei im Uhrzeigersinn, aber es ist auch möglich das Transportband entgegen dem Uhrzeigersinn umlaufend zu bewegen. Dabei ist ein oben liegendes Transporttrum des Transportbandes 20 derart angeordnet, dass es sich geradlinig durch die Prozesskammer 4 hindurch erstreckt. Somit wird ein Substrat 2 von links nach rechts durch die Prozesskammer 4 hindurch bewegt. Die Rückführung des Transportbandes 20 erfolgt außerhalb der Prozesskammer 4, um dort beispielsweise Kühl- und/oder Reinigungsprozesse an dem Transportband 20 vornehmen zu können. Das Transportband 20 sollte möglichst vollständig innerhalb des Vakuumbereichs angeordnet sein, kann aber bei einer geeigneten Anordnung auch wenigstens teilweise außerhalb des Vakuumbereichs liegen. Statt eines Transportbandes 20 kann die Transporteinheit 6 beispielsweise auch einen anderen Transportmechanismus, wie beispielsweise Transportrollen oder auch eine Magnetführung aufweisen.

Die Transporteinheit 6 kann optional als Ganzes auf und ab bewegt werden, wie durch den Doppelpfeil A angezeigt ist. Hierdurch ist es möglich die Transporteinheit 6 und insbesondere dessen Transporttrum näher an der oberen Wand 12 oder der unteren Wand 14 zu platzieren, wie nachfolgend noch näher erläutert wird.

Innerhalb der Prozesskammer 4 ist ferner die Plasmaeinheit 8 angeordnet. Die Plasmaeinheit 8 besteht aus einer Vielzahl von Plasmaelektroden 24. Die Plasmaelektroden sind als Mikrowellenstäbe ausgebildet. Die Mikrowellenstäbe sind des einseitig mit Mikrowellen beaufschlagten Typs, wie er beispielsweise aus der WO 2010/015385 A bekannt ist, die hinsichtlich des Aufbaus eines bevorzugten Mikrowellenstabes durch Bezugnahme aufgenommen wird. Insbesondere besitzt der Mikrowellenstab einen Innenleiter der in einem ersten Teilbereich vollständig von einem Außenleiter umgeben ist. Benachbart zu diesem Teilbereich schließt sich ein Teilbereich an, in dem der Außenleiter eine sich zu einem freien Ende erweiternde Öffnung vorsieht. Im Bereich der sich erweiternden Öffnung wird Mikrowellenleistung zur Erzeugung eines Plasmas ausgekoppelt. Bei der Darstellung sind insgesamt 10 Mikrowellenstäbe vorgesehen, die über nicht dargestellte Magnetrons mit Mikrowellen beaufschlagt werden. Dabei können jeweils zwei Mikrowellenstäbe über ein gemeinsames Magnetron beaufschlagt werden.

Die Mikrowellenstäbe können eine oder mehrere Plasmazündvorrichtung(en) aufweisen. Die Plasmastäbe können aber auch einen anderen Aufbau von Innen und Außenleiter besitzen.

Der Aufbau der Plasmastäbe kann so gewählt werden, dass ein hierdurch erzeugtes Plasma in seiner Ausdehnung (insbesondere in Längsrichtung der Plasmastäbe) begrenzt wird und nicht mit Wänden der Prozesskammer in Berührung kommt. Hierdurch könnten ansonsten unerwünschte reaktive Spezies entstehen, die zu Metallverunreinigungen auf dem Substrat führen könnten. Durch die Verwendung von Aluminium als Prozesskammermaterial kann eine entsprechende Verunreinigung ebenfalls vermieden werden, sofern eine kritische Bombardement Energie von 14 eV von aus dem Plasma austretenden Spezies nicht überschritten wird.

Die Plasmastäbe 24 erstrecken sich jeweils senkrecht zur Zeichnungsebene quer durch die Prozesskammer 4. Von links nach rechts, d.h. von einem Eingangsende zu einem Ausgangsende der Prozesskammer 4 sind die Plasmastäbe jeweils gleichmäßig beabstandet angeordnet. Die oben beschrieben Vorrichtung ist als Durchlaufvorrichtung konzipiert.

Fig. 2 zeigt eine schematische Schnittansicht einer alternativen Vorrichtung 1 zum Aufbringen von Schichten auf einem Substrat 2 gemäß einer alternativen Ausführungsform. Bei der Beschreibung dieser Ausführungsform werden dieselben Bezugszeichen wie zuvor verwendet, sofern gleiche oder ähnliche Elemente beschrieben werden.

Die Vorrichtung 1 besitzt wieder ein Gehäuse, das nur schematisch bei 3 dargestellt ist. Das Gehäuse 3 ist wiederum als ein Vakuumgehäuse ausgeführt, und kann über eine nicht dargestellte Vakuumeinheit auf Vakuumdruck abgepumpt werden.

Innerhalb des Gehäuses 3 ist eine Prozesskammer 4 definiert. Die Vorrichtung 1 besitzt ferner eine Substrattrageinheit 6, eine Plasmaeinheit 8 sowie eine optionale Heizeinheit 10. Die Trageinheit 6 besitzt eine Substratauflage 40, die über eine Welle 42 drehbar innerhalb der Prozesskammer 4 getragen wird, wie durch den Pfeil B dargestellt ist. Die Welle 42 ist hierfür mit einer nicht näher dargestellten Dreheinheit verbunden. Darüber hinaus ist die Welle 42 und somit die Auflage 40 auf und ab bewegbar, wie durch den Doppelpfeil C dargestellt ist. Hierdurch lässt sich die Auflageebene der Auflage 40 innerhalb der Prozesskammer 4 nach oben bzw. nach unten verstellen, wie nachfolgend noch näher erläutert wird.

Die Plasmaeinheit 8 besteht wiederum aus zehn Plasmastäben 24, die desselben Typs sein können, wie zuvor beschrieben. Die Plasmastäbe können wiederum paarweise über nicht dargestellte Magnetrons mit Leistung beaufschlagt werden. Die Plasmastäbe 24 können optional über jeweilige Führungen 46 individuell auf und ab verschiebbar innerhalb der Prozesskammer 4 getragen sein, wie durch den Doppelpfeil D angezeigt ist. In einem solchen Fall könnte die Auf- und Ab- Bewegbarkeit der Trageinheit 6 entfallen, sie kann aber auch zusätzlich vorgesehen werden. Hierdurch sind lokale Änderungen des Abstands zwischen Plasmaelektrode 24 und dem Substrat 2 möglich. Insbesondere ist es hierdurch möglich, in Kombination mit der Rotation eines Substrats 2 durch die Trageinheit 6 zum Beispiel in einem Randbereich der Substrate 2 größer oder kleinere Abstände im Vergleich zu einem Mittelbereich davon vorzusehen. Ferner ist es von Vorteil, wenn die Plasmaelektroden 24 und/oder die Lampen 31 über die Abmessungen des Substrats 2 hinweg gehen. Wiederum kann eine Schutzvorrichtung vorgesehen sein, welche das Substrat 2 wenigstens teilweise in seiner Ebene umgibt, um Randeffekte zu vermeiden. Die Schutzvorrichtung kann hinsichtlich der Rotation statisch oder auch rotierbar angeordnet sein.

Obwohl dies nicht dargestellt ist, kann zwischen den Plasmastäben 24 und dem Substrat 2 ein Gitter vorgesehen sein, das über eine nicht dargestellte Kühleinheit gekühlt werden kann, um einen durch ein Plasma bedingten Aufheizeffekt des Substrats abzumildern. Das Gitter kann optional aus elektrisch leitendem Material bestehen, um eine elektrische Vorspannung am Gitter erzeugen zu können. Dies kann dann beispielsweise über eine entsprechend Steuereinheit mit unterschiedlichen elektrischen Vorspannungen beaufschlagt werden. Sowohl eine Abstandeinstellung zwischen Plasmaelektrode 24 und Substrat 2 als auch eine Beaufschlagung eines oben beschriebenen Gitters mit unterschiedlichen elektrischen Vorspannungen kann die Wechselbeziehung zwischen Plasma und Substrat beeinflussen, wie in der oben genannten DE 10 2011 100 024 beschrieben ist.

Die optionale Heizeinheit 10, die für das erfindungsgemäße Verfahren in der Regel nicht eingesetzt wird, wohl aber für andere Prozesse, die in der Vorrichtung 1 erfolgen können, besteht aus einer Vielzahl von Strahlungsquellen 30, die parallel oder auch senkrecht zu den Plasmaelektroden 24 angeordnet sein können. Die Strahlungsquellen weisen jeweils eine Lampe, wie beispielsweise eine Bogen- oder Halogenlampe auf, die von einer Quarzröhre 32 umgeben ist.

Die Vorrichtung 1 weist vorzugsweise wenigstens eine Temperaturmesseinheit auf, um die Temperatur des Substrats 2 zu ermitteln. Die ermittelte Temperatur kann an eine nicht dargestellte Steuereinheit weitergeleitet werden, die dann anhand einer Temperaturvorgabe unterschiedliche Prozessparameter regeln kann, um die Substrattemperatur auf einen vorbestimmten Wert zu bringen und insbesondere unter einem vorbestimmten Maximalwert zu halten.

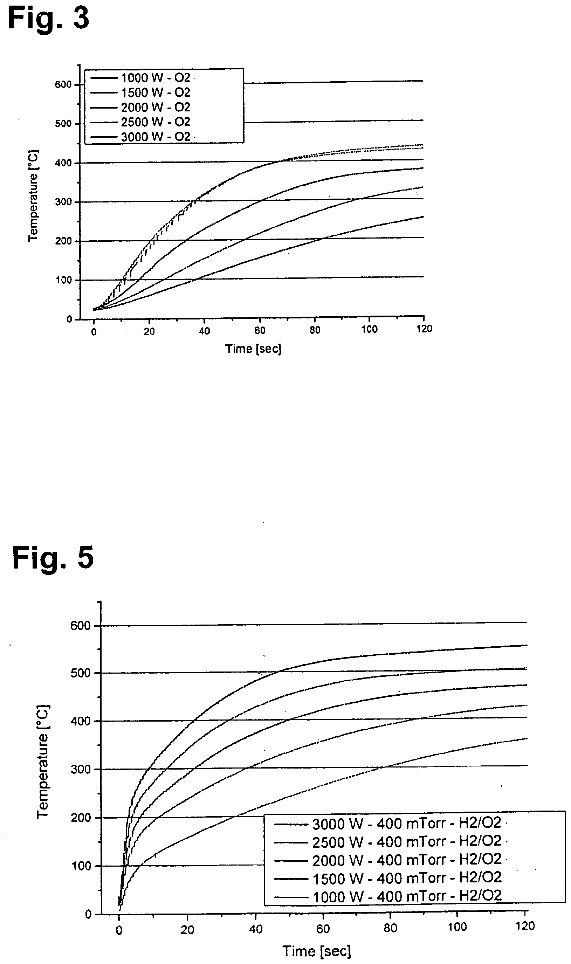

Die Fig. 3 bis 6 zeigen Kurven von zeitabhängigen Temperaturerhöhung eines Wafers während einer Plasmaoxidation in einer Vorrichtung 1 gemäß Fig. 2 bei unterschiedlichen Prozessbedingungen.

So zeigt Fig. 3 die Temperaturerhöhung eines 300 mm Wafers während einer Plasmaoxidation bei 34,67 Pa (260 mTorr), einem Abstand zwischen Plasmastäben und Wafer von 20 mm in einer reinen $O_2$-Atmosphäre. Dabei ist der Abstand von einem die Plasmastäbe umgebenden dielektrischen Hüllrohr aus gemessen. Die unterschiedlichen Kurven entsprechen unterschiedlichen Leistungen der Magnetrons, wobei insgesamt fünf Magnetrons vorgesehen sind, die jeweils zwei Magnetstäbe mit Mikrowellen beaufschlagen. Die Kurven zeigen, dass höhere Leistungen der Magnetrons wenigstens nach einiger Zeit zu höheren Temperaturen führen. Hierüber ist auch eine Zuordnung der Kurven zu den angegebenen Leistungswerten für die Magnetrons möglich. Die Kurve für eine Leistung von 3000 Watt pro Magnetron erzeugte nach 120 Sekunden den höchsten Temperaturwert und die Kurve für eine Leistung von 1000 Watt pro Magnetron erzeugte den niedrigsten Temperaturwert.

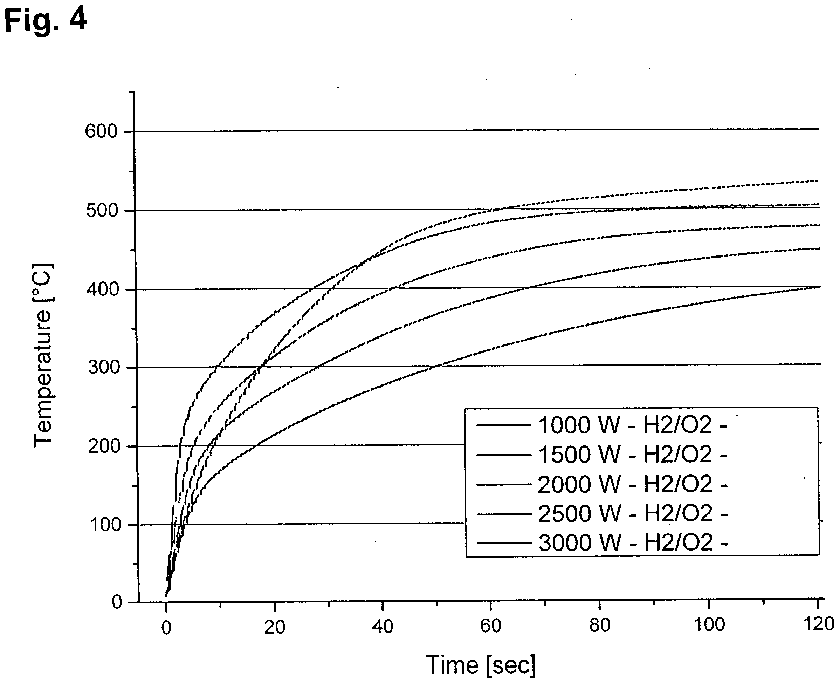

Fig. 4 zeigt entsprechend Fig. 3 die Temperaturerhöhung eines 300 mm Wafers während einer Plasmaoxidation bei 34,67 Pa (260 mTorr), einem Abstand zwischen Plasmastäben und Wafer von 20 mm in einer reinen $H_2/O_2$-Atmos-phäre, mit einem Mischungsverhältnis von 1:1. Die Kurven zeigen, dass in einer reinen $O_2$ Atmosphäre im Vergleich zu einer $H_2/O_2$-Atmosphäre bei ansonsten gleichbleibenden Bedingungen niedrigere Temperaturen erreicht werden.

Fig. 5 zeigt entsprechend Fig. 4 die Temperaturerhöhung eines 300 mm Wafers während einer Plasmaoxidation bei 53,33 Pa (400 mTorr), einem Abstand zwischen Plasmastäben und Wafer von 20 mm in einer reinen $H_2/O_2$-Atmos-phäre, mit einem Mischungsverhältnis von 1:1. Die Kurven zeigen wiederum, dass höhere Leistungen der Magnetrons wenigstens nach einiger Zeit zu höheren Temperaturen führen. Insbesondere zeigen sie auch eine raschere und höhere Erwärmung des Wafers.

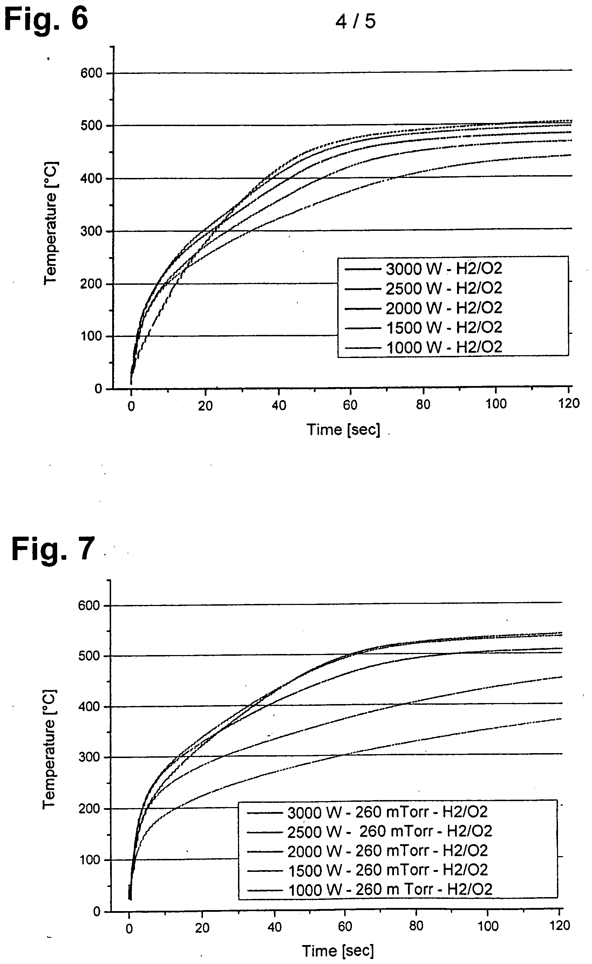

Fig. 6 zeigt entsprechend Fig. 5 die Temperaturerhöhung eines 300 mm Wafers während einer Plasmaoxidation bei 13,87 Pa (104 mTorr), einem Abstand zwischen Plasmastäben und Wafer von 20 mm in einer reinen $H_2/O_2$-Atmosphäre, mit einem Mischungsverhältnis von 1:1. Die Kurven zeigen wiederum, dass höhere Leistungen der Magnetrons wenigstens nach einiger Zeit zu höheren Temperaturen führen. Insbesondere zeigen sie auch eine raschere und meist höhere Erwärmung des Wafers im Vergleich zur Fig. 4. Insgesamt rücken die Kurven bei Fig. 5 näher zusammen, was darauf hinweist, dass bei geringeren Drücken die Leistungsabhängigkeit infolge größerer Ausdehnung des Plasmas abnimmt.

Fig. 7 zeigt entsprechend Fig. 6 die Temperaturerhöhung eines 300 mm Wafers während einer Plasmaoxidation bei 34,67 Pa (260 mTorr), einem Abstand zwischen Plasmastäben und Wafer von 60 mm in einer reinen $H_2/O_2$-Atmosphäre, mit einem Mischungsverhältnis von 1:1. Die Kurven zeigen wiederum, dass höhere Leistungen der Magnetrons wenigstens nach einiger Zeit zu höheren Temperaturen führen. Insbesondere zeigen sie für geringere Leistungen eine flachere Kurve, bedingt durch den größeren Abstand zwischen Plasma und Substrat.

Aus den obigen beispielhaften Kurven lassen sich mögliche Prozessbedingungen für eine Oxidation unterhalb von 200 °C extrahieren und die bei diesen Bedingungen gewachsenen Oxidschichtdicken bestimmen.

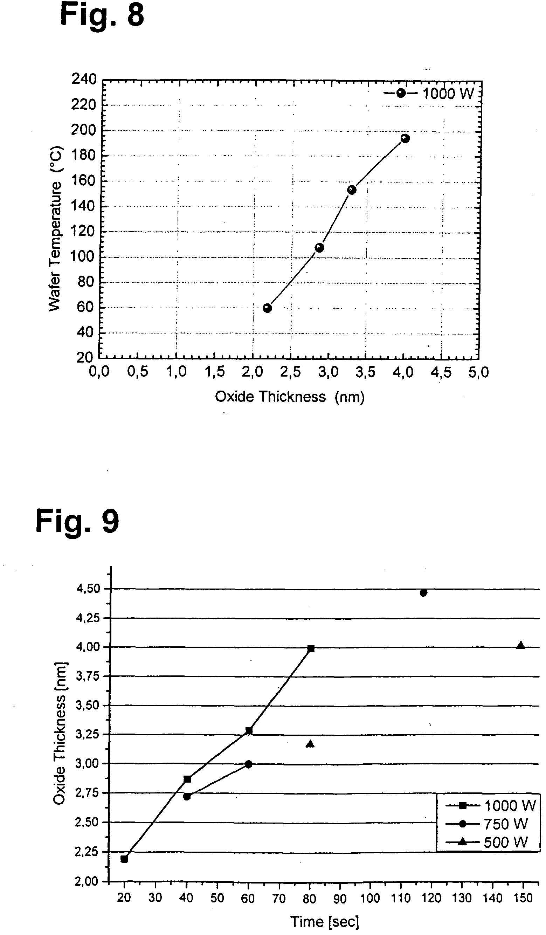

Fig. 8 zeigt eine Kurve einer Wafertemperatur in Abhängigkeit vom Oxidwachstum auf einem Wafer während einer Plasmaoxidation Insbesondere zeigt Fig. 8 eine beispielhafte Kurve der Abhängigkeit der Wafertemperatur (unter 200°C) von der gewachsenen Oxiddicke bei den Prozessbedingungen gemäß Fig. 3 und einer Leistung der Magnetrons von 1000 Watt.

Fig. 9 zeigt Kurven eines zeitabhängigen Oxidwachstums auf einem Wafer während einer Plasmaoxidation bei den Prozessbedingungen gemäß Fig. 3 und unterschiedlichen Leistungen der Magnetrons. Es ist erkennbar, dass bei den oben beschriebenen Bedingungen mit 1000W Leistung pro Magnetron (also 500 W Leistung pro Plasmastab) bei Prozesszeiten bis zu 80 sec. Oxide mit einer Dicke bis zu 4 nm wachsen, wobei die Wafer Temperatur stets $\leq 200$ °C ist. Wird die Leistung auf 750 W pro Magnetron verringert, so lassen sich innerhalb von bis zu 120 sec. Oxiddicken bis zu 4,5 nm Dicke wachsen, wobei die Wafertemperatur ebenfalls stets unterhalb von 200 °C bleibt. Mit Leistungen von 500 W pro Magnetron lassen sich innerhalb von bis zu 150 sec. Prozesszeit Oxiddicken bis zu 4 nm Dicke erreichen, ebenfalls mit der Nebenbedingung, dass die Wafertemperatur stets unterhalb 200 °C bleibt.

Die Figuren 3 bis 8 stellen nur einige Kurven dar, aus denen die Erfinder einen Variablensatz extrahiert haben, der eine Tieftemperaturoxidation eines Substrats bei Temperaturen unter 200°C ermöglicht. Dabei enthält der Variablensatz unterschiedliche einstellbare Prozessbedingungen, die jeweils einen Einfluss auf eine Plasmaoxidation haben. Der Variablensatz gilt für eine Plasmaoxidation bei der ein Plasma mittels Mikrowellen aus einem Sauerstoff enthaltenden Gas oder Gasgemisch erzeugt wird, wobei die Mikrowellen von wenigstens einem Magnetron über wenigstens ein dem Substrat gegenüberliegenden Mikrowellenstab, der einen Außenleiter und einen Innenleiter aufweist, in das Gas oder Gasgemisch, das sich in einer Prozesskammer befindet, eingekoppelt werden.

Der Variablensatz umfasst folgende Prozessbedingungen: Mittlere Mikrowellen-Leistungsdichte P = 0,8 - 10 $W/cm^2$, Plasmadauer t = 0.1 - 600 sec., Prozesskammerdruck p = 2,67 - 266,64 Pa (20 - 2000 mTorr), und einem Abstand Substratoberfläche zu Mikrowellenstab d = 5 - 120 mm. Insbesondere sollten die Variablen folgende Werte aufweisen: Mittlere Mikrowellen-Leistungsdichte P = 0,8 - 10 $W/cm^2$, Plasmadauer t = 0.1 - 300 s (insbesondere t = 0,1 - 150 s), Prozesskammerdruck p = 10,67 - 133,32 Pa (80 - 1000 mTorr), und Abstand Substratoberfläche zu Mikrowellenstab d = 8 - 80 mm. Die oben genannten und gegebenenfalls weitere Prozessbedingungen müssen derart aufeinander abgestimmt werden, dass das Substrat auf einer Temperatur unter 200°C gehalten wird und ein Oxidwachstum auf der zum Plasma weisenden Oberfläche des Substrats induziert wird.

Ein entsprechende Abstimmung ist beispielsweise für ein Oxidwachstum von < 4,5 nm bei einer Substrattemperatur von T < 200°C gegeben, wenn die folgende Gleichung erfüllt ist:

$$P^A \cdot t^B \cdot p^C \cdot \exp(-(d-d_0)/\lambda) < K,$$

wobei die mittlere Mikrowellen-Leistungsdichte P in $[W/cm^2]$ angegeben wird, die Plasma-Brenndauer t in [s], der Prozesskammerdruck p in [Pa] und der Abstand Plasmaquelle zu Waferoberfläche d in [mm].

Die Gleichungsparameter sind dabei wie folgt definiert:

$d_0$ ist ein Abstandsoffset in [mm] im Bereich von 0 - 30 mm,
A ist eine charakteristische Länge in [mm] im Bereich 30 - 120 mm,
A, B und C sind wählbare Koeffizienten im Bereich
A = 0,8 - 1,5;
B = 0,5 - 1,3;
C = -1 - -0,3, und
K ist eine Konstante im Bereich 11 - 4. Dabei kann zum Beispiel der Abstandskoeffizient einer Eindringtiefe der Mikrowellen in den den Mikrowellenstab umgebenden Raum und die charakteristische Länge einer abfallenden Plasma-, Ionen-, oder Elektronendichte entsprechen.

Vorzugsweise sollten die folgenden Parameter bei $d_0$ = 0 - 10 mm; A = 35 - 80 mm; A = 1 - 1,2; B = 0,8 - 1; C = -0,8 - -0,7; und K = 8 - 4 liegen. Insbesondere könnten diese Parameter folgende Werte besitzen: $d_0$ = 0 mm; $\lambda$ = 70 mm; A = 1,1; B = 0,9; C = -2/3; und K = 4.

Der Parametersatz ist in einer der oben beschriebenen Vorrichtungen, insbesondere der Vorrichtung der Fig. 2 einsetzbar. Aber der angegebene Parametersatz sollte auch bei anderen Aufbauten, die beispielsweise eine andere Anzahl von Mikrowellenstäben und Magnetrons einsetzen, einsetzbar sein. Der Parametersatz ist insbesondere geeignet, die Wechselwirkung der Prozessvariablen zu beschreiben, welche für die Bildung von Oxidschichtdicken bis 4,5 nm in reiner Sauerstoffatmosphäre bei Substrattemperaturen unterhalb von 200 °C benötigt werden. Je nach Gaszusammensetzung sind natürlich auch noch andere Oxidschichtdicken denkbar. So kann zum Beispiels über das Zusetzen von inertem Gas bis zu 90% zu $O_2$ oder einer $O_2/H_2$ Mischung die erforderliche Leistung zum Erzeugen und aufrechterhalten eines Plasmas verändert werden. Das Gas oder Gasgemisch kann auch $N_2$, NO, $N_2O$, $NH_3$ oder $D_2$ enthalten. Auch der Einsatz eines gekühlten Gitters zwischen den Mikrowellenstäben und dem Substrat oder auch eine Rückseitenkühlung des Substrats kann neben den oben genannten Prozessvariablen einen Einfluss darauf haben, dass die Substrattemperatur nicht über 200°C ansteigt.

Die Erfindung wurde zuvor anhand bevorzugter Ausführungsformen der Erfindung beschrieben, ohne auf die konkreten Ausführungsformen begrenzt zu sein. Dies gilt insbesondere für die angegebene Anzahl von Mikrowellenstäben und der entsprechenden Anzahl von Magnetrons.

## Patentansprüche

1.   Verfahren zum Ausbilden einer Oxidschicht auf einem Halbleitersubstrat das die folgenden Schritte aufweist:

Erzeugen eines Plasmas benachbart zu wenigstens einer Oberfläche des Substrats, wobei das Plasma mittels Mikrowellen aus einem Sauerstoff enthaltenden Gas oder Gasgemisch erzeugt wird, wobei die Mikrowellen von wenigstens einem Magnetron über wenigstens ein dem Substrat gegenüberliegenden Mikrowellenstab, der einen Außenleiter und einen Innenleiter aufweist, in das Gas, das sich in einer Prozesskammer befindet, eingekoppelt werden;
Einstellen der folgenden Prozessbedingungen:

| | |
|---|---|
| mittlere Mikrowellen-Leistungsdichte in [W/cm$^2$] auf | P = 0,8 - 10 W/cm$^2$; |
| Plasmadauer in [s] auf | t = 0.1 - 600 sec |
| Prozesskammerdruck in [Pa] auf | p = 2,67 - 266,642 Pa |
| (20 - 2000 mTorr); | |
| Abstand Substratoberfläche zu Mikrowellenstab in [mm] auf | d= 5 - 120 mm, |

wobei die oben genanten und gegebenenfalls weitere Prozessbedingungen für ein Oxidwachstum von < 4,5 nm bei einer Substrattemperatur von T < 200°C so eingestellt werden, dass sie die folgende Gleichung erfüllen:

$$P^A \cdot t^B \cdot p^C \cdot \exp(-(d-d_0)/\lambda) < K,$$

wobei die Gleichungsparameter wie folgt definiert sind:

$d_0$ ist ein Abstandsoffset in [mm] im Bereich von 0 - 30 mm,
$\lambda$ ist eine charakteristische Länge in [mm] im Bereich 30 - 120 mm,
A, B und C sind wählbare Koeffizienten im Bereich
A = 0,8 - 1,5;
B = 0,5 - 1,3;
C = -1 - -0,3, und
K ist eine Konstante im Bereich 11 - 4.

2.   Verfahren nach Anspruch 1, wobei die Parameter in den folgenden Bereichen liegen:

$d_0$ = 0 - 10 mm;
$\lambda$ = 35 - 80 mm;
A= 1 - 1,2;
B = 0,8 - 1;
C = -0,8 - -0,7;
K = 8 - 4.

3. Verfahren nach Anspruch 1, wobei die Parameter folgende Werte besitzen:

$d_0$ = 0 mm;
$\lambda$ = 70 mm;
A = 1,1;
B = 0,9;
C = -2/3;
K = 4.

4. Verfahren nach einem der vorhergehenden Ansprüche, wobei die mittlere Mikrowellen-Leistungsdichte zum Erzeugen des Plasmas bei wenigstens 1,3 W/cm$^2$ liegt.

5. Verfahren nach einem der vorhergehenden Ansprüche, wobei das Plasma über wenigstens einen einseitig mit Mikrowellen beaufschlagten Mikrowellenstab erzeugt wird, wobei der Außenleiter eine sich zu einem freien Ende der Elektrode erweiternde Auskopplungsöffnung bildet.

6. Verfahren nach einem der vorhergehenden Ansprüche, wobei das Gas $O_2$ oder $O_2/H_2$ in einer Größenordnung von 6 - 100% enthält, wobei der Rest ein inertes Gas ist, wie beispielsweise Ar, He, Xe, Kr.

7. Verfahren nach einem der Ansprüche 1 bis 5, wobei das Gas $N_2$, NO, $N_2O$, $NH_3$ oder $D_2$ enthält.

8. Verfahren nach einem der vorhergehenden Ansprüche, wobei eine Gitterstruktur zwischen dem wenigstens einen Mikrowellenstab und dem Substrat vorgesehen ist, die über wenigstens einen Teilabschnitt des Verfahrens, bei dem das Plasma erzeugt ist, gekühlt wird.

9. Verfahren nach einem der vorhergehenden Ansprüche, wobei das Substrat über seine Rückseite gekühlt wird.

10. Verfahren nach einem der vorhergehenden Ansprüche, wobei das Halbleitersubstrat ein Siliziumsubstrat ist.

**Claims**

1. A method for forming an oxide layer on a semiconductor substrate, the method comprising:

generating a plasma adjacent to at least one surface of the substrate, wherein the plasma is generated via microwaves from a gas or a mixture of gases containing oxygen, wherein the microwaves are coupled into the gas, which is contained in a process chamber, by at least one magnetron via at least one microwave rod arranged opposite to the substrate, the microwave rod comprising an outer conductor and an inner conductor;
setting the following process conditions:

| | |
|---|---|
| mean microwave power density in [W/cm$^2$] to | P = 0,8 - 10 W/cm$^2$; |
| plasma duration in [s] to | t = 0.1 - 600 s; |
| process chamber pressure in [Pa] to | p = 2.67 - 266.64 Pa (20 - 2000 mTorr); |
| distance between substrate surface and microware rod in [mm] to | d= 5 - 120 mm, |

wherein the above and optionally further process conditions are set for an oxide growth of <4.5 nm at a substrate temperature of T <200°C such that the following equation is fulfilled:

$$P^A \bullet t^B \bullet p^C \bullet \exp(-(d-d_0)/\lambda) < K,$$

wherein the parameters of the equation are defined as follows:

$d_0$ is a distance offset in [mm] in the range of 0 - 30 mm,
$\lambda$ is a characteristic length in [mm] in the range of 30 - 120 mm,
A, B and C are choosable coefficients in the range of
A = 0.8 - 1.5;
B = 0.5 - 1.3;
C = -1 - -0.3, and
K is a constant in the range of 11 - 4.

2. The method of claim 1, wherein the parameters are in the following ranges:

$d_0$ = 0 to 10 mm;
$\lambda$ = 35 to 80 mm;
A = 1 to 1.2;
B = 0.8 to 1;
C = -0.8 to -0.7;
K = 8 to 4.

3. The method of claim 1, wherein the parameters have the following values:

$d_0$ = 0 mm;
$\lambda$ = 70 mm;
A = 1.1;
B = 0.9;
C = -2/3;
K = 4.

4. The method of any one of the preceding claims, wherein the mean microwave power density for generating the plasma is at least 1.3 $W/cm^2$.

5. The method of any one of the preceding claims, wherein the plasma is generated by at least one microwave rod which is supplied with microwaves from a single side, wherein the outer conductor forms an emission opening which widens toward the free end of the electrode.

6. The method of any one of the preceding claims, wherein the gas contains $O_2$ or $O_2/H_2$ in the order of 6 - 100%, wherein the rest may be an inert gas, such as Ar, He, Xe, Kr.

7. The method of any one claims 1 to 5, wherein the Gas contains $N_2$, NO, $N_2O$, $NH_3$ or $D_2$.

8. The method of any one of the preceding claims, wherein a grid structure is provided between the at least one microwave rod and the substrate, which grid maybe cooled over at least a portion of the method, in which the plasma is generated.

9. The method of any one of the preceding claims, wherein the substrate is cooled via its backside.

10. The method of any one of the preceding claims, wherein the semiconductor substrate is a silicon substrate.

**Revendications**

1. Procédé de formation d'une couche d'oxyde sur un substrat semi-conducteur, comprenant les étapes de :

générer un plasma adjacent à au moins une surface du substrat, dans lequel le plasma est généré par des microondes à partir d'un gaz ou d'un mélange gazeux contenant de l'oxygène, les microondes étant couplées dans le gaz, qui est contenu dans une chambre de traitement, par au moins un magnétron via au moins une tige microondes opposée au substrat, la tige hyperfréquence comportant un conducteur externe et un conducteur interne ;

définir les conditions de mise en oeuvre suivantes :

densité de puissance microondes moyenne en [w/cm$^2$] à P = 0,8 - 10 W/cm$^2$ ;
durée du plasma en [s] à t = 0,1 - 600 s ;
pression de la chambre de traitement en [Pa] à p = 2,67 - 266,64 Pa (20 - 2000 mTorr) ;
distance entre la surface du substrat et la tige microondes en [mm] à d = 50 - 120 mm,
dans lequel les conditions de mise en oeuvre ci-dessus et éventuellement d'autres conditions sont fixées pour une croissance d'oxyde <4,5 nm à une température de substrat de T <200°C de sorte que l'équation suivante est respectée :

$$P^A . t^B . p^C . \exp\left(-(d-d_0)/\lambda\right) < K,$$

où les paramètres de l'équation sont définis de la façon suivante :

$d_0$ est un décalage en [mm] dans la plage 0 - 30 mm,
$\lambda$ est une longueur caractéristique en [mm] dans la plage 30 - 120 mm,
A, B et C sont des coefficients sélectionnables dans les plages
A = 0,8 - 1,5 ;
B = 0,5 - 1,3 ;
C = -1 - -0,3, et
K est une constante dans la plage 11 - 4.

2. Procédé selon la revendication 1, dans lequel les paramètres sont dans les plages suivantes :

$d_0$ = 0 à 10 mm ;
$\lambda$ = 35 à 80 mm ;
A = 1 à 1,2 ;
B = 0,8 à 1 ;
C = -0,8 à -0,7 ;
K = 8 à 4.

3. Procédé selon la revendication 1, dans lequel les paramètres ont les valeurs suivantes :

$d_0$ = 0 mm ;
$\lambda$ = 70 mm ;
A = 1,1 ;
B = 0,9 ;
C = -2/3 ;
K = 4.

4. Procédé selon l'une quelconque des revendications précédentes, dans lequel la densité de puissance microondes moyenne pour générer le plasma est d'au moins 1,3 w/cm$^2$.

5. Procédé selon l'une des revendications précédentes, dans lequel le plasma est généré par au moins une tige microondes soumise à des microondes d'un seul côté, le conducteur externe formant une ouverture d'émission qui s'élargit en direction de l'extrémité libre de l'électrode.

6. Procédé selon l'une des revendications précédentes, dans lequel le gaz contient $O_2$ ou $O_2/H_2$ dans une proportion de 6 - 100%, le reste pouvant être un gaz inerte, tel que Ar, He, Xe, Kr.

7. Procédé selon l'une quelconque des revendications 1 à 5, dans lequel le gaz contient $N_2$, NO, $N_2O$, $NH_3$ ou $D_2$.

8. Procédé selon l'une des revendications précédentes, dans lequel une structure de grille est prévue entre la au moins une tige microondes et le substrat, la grille pouvant être refroidie pendant au moins une partie du procédé au cours duquel le plasma est généré.

9. Procédé selon l'une des revendications précédentes, dans lequel le substrat est refroidi par sa face arrière.

10. Procédé selon l'une des revendications précédentes, dans lequel le substrat est un substrat de silicium.

**Fig. 1**

**Fig. 2**

# Fig. 3

# Fig. 5

**Fig. 4**

## Fig. 6

## Fig. 7

# Fig. 8

# Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7381595 B2
- US 6037017 A
- US 20070026540 A1
- US 5492735 A
- US 5281557 A
- US 2009263919 A1
- US 2010247805 A1
- EP 1361605 A1
- WO 2010015385 A
- DE 19722272
- DE 102011100024